# EUROPEAN PATENT APPLICATION

(11) **EP 4 550 407 A1**
(43) Date of publication of application: **07.05.2025**
(21) Application number: 23206783.5
(22) Date of filing: 30.10.2023
(51) Int. Cl.: H01L 23/46, F28F 3/12, H01L 23/433, H01L 23/367, H01L 21/48, H05K 7/20, F28D 21/00, H01L 23/473, H01L 23/467

(54) **FLUID-BASED COOLING UNIT AND METHOD FOR MANUFACTURING THEREOF**

(71) Applicant: M-Arms d.o.o., 1273 Dole pri Litiji (SI)
(72) Inventor: COTAR, Matjaz, 4220 Skofja Loka (SI); MANDELJ, Ziga, 1273 Dole pri Litiji (SI)
(74) Representative: Schaumburg und Partner Patentanwälte mbB

(57) **Abstract**

A cooling unit (100) comprises at least one inlet channel (204) configured to allow a cooling fluid to flow into the cooling unit (100), and at least one outlet channel (118) configured to allow a cooling fluid to flow out of the cooling unit (100). The cooling unit (100) also comprises at least one cooling channel (112a, 112b, 112a', 112b') connecting the inlet channel (204) to the outlet channel (118) allowing the cooling fluid to flow from the inlet channel (204) to the outlet channel (118) in order to remove heat from the heat generating element. At least one cooling channel (112a, 112b, 112a', 112b') comprises cylindrical blind holes. The cylindrical blind holes are arranged such that the circular cross-sections of the blind holes partly overlap in order to form at least part of the cooling channel (112a, 112b, 112a', 112b').

## Description

### Technical field

The invention relates to a fluid based cooling unit for cooling a heat generating element. The cooling unit comprises at least one inlet channel configured to allow a cooling fluid to flow into the cooling unit, and at least one outlet channel configured to allow a cooling fluid to flow out of the cooling unit. The cooling unit further comprises at least one cooling channel connecting the inlet channel to the outlet channel allowing the cooling fluid to flow from the inlet channel to the outlet channel in order to remove heat from the heat generating element.

### Background

In fluid based cooling, a cooling fluid, that is a gas or a liquid, is used to remove excess heat from a heat generating element. The heat generating element may be, for example, an electronic component such as a CPU or a GPU, an engine such as an electric motor or an internal combustion engine, or an energy storage such as a battery or a super capacitor.

Typical fluid based cooling units comprise one or more elements in thermal contact with the heat generating element made from a material having a high thermal conductivity. Such elements are often called heat sinks. The cooling fluid is directed through a heat sink structure formed in the heat sinks in order to carry excess heat away from the heat sinks, and thereby the heat generating element. The design of the heat sink structure greatly influences the performance of the fluid based cooling unit. Typical heat sink structures comprise a number of narrow channels that are arranged parallel to each other. To increase the surface area of the cooling unit and thus its efficiency, the number of channels must be increased to a maximum. This requires narrow channels with thin walls between the channels. The thin walls formed between the channels are also called cooling fins.

The known design has a few disadvantages. The narrow channels suppress vortices making the flow of the cooling fluid laminar. However, this reduces the heat transfer. Further, the thin walls between the channels do not dissipate heat efficiently. However, the large surface area of the narrow channels also creates a lot of viscous drag which increases the required pumping power.

In the state of the art, the heat sink structure is formed by milling a block of material, for example using a CNC machine, or by sawing, for example using a circular saw. However, the known methods of forming the heat sink structure have severe limitations. For example, using a circular saw, only straight channels may be formed. When using a CNC machine, one is often limited to using small diameter bits, making the manufacturing of the channels very tedious.

### Summary

It is an object of the present invention to provide a fluid-based cooling unit that has a high cooling performance and is easy to manufacture.

The aforementioned object is achieved by the subject-matter of the independent claims. Advantageous embodiments are defined in the dependent claims and the following description.

The proposed fluid based cooling unit solves the object by having at least one cooling channel comprising cylindrical blind holes. The cylindrical blind holes are arranged such that the circular cross-sections of the blind holes partly overlap in order to form at least part of the cooling channel.

The cooling channel is part of the heat sink structure formed in the cooling unit through which the cooling fluid is passed in order to remove excess heat from the heat generating element. The cooling channel is at least in part formed by a series of blind holes that can be formed very easily, in particular by drilling. This makes the proposed cooling unit very easy to manufacture. Since at least a part of the cooling channel is formed by the overlapping blind holes, this part of the channel has a jagged structure. This jagged structure causes the flow of the cooling fluid to become turbulent, thereby greatly improving the cooling performance of the cooling unit. Thus, the proposed cooling unit has a heat sink structure design with a greatly increased efficiency that is easy to manufacture. As an additional benefit, the cooling channels may have a larger cross-section and the number of them can be decreased, which causes less viscous drag despite the turbulent flow, thus requiring considerably less power to pump the cooling fluid.

The device described herein is described as a fluid based cooling unit. However, the device may also be used as a heat transfer unit in general, i.e. the device may be used to transfer heat to an element instead of removing heat from a heat generating element. For example, the device may be used to heat a biological sample in an incubation device by pumping a heated fluid through the device. When the device is used as a heat transfer unit, the cooling fluid is replaced by a suitable heat transfer fluid.

In an embodiment, the cooling unit comprises at least two cooling channels arranged next to each other such that a wall is formed between the at least two channels. The wall between the cooling channels forms a cooling fin of the cooling unit. Alternatively, or additionally, a single cooling channel may run meandering such that a wall is formed between two sections of the cooling channel. The wall formed between two sections of the cooling channel forms a cooling fin of the cooling unit. A single cooling channel may also split in order to form the two cooling channels. The two cooling channels may also merge into a single cooling channel. Due to the increased efficiency of the proposed heat sink structure design, the walls between cooling channels may be made thicker, increasing their ability to dissipate heat away from the heat generating element. This also allows the channels to be made deeper, thereby increasing surface area of the heat sink structure and allowing more cooling fluid to pass through the channel, thereby further increasing the cooling efficiency of the cooling unit.

In another embodiment, at least one of the blind holes has a diameter different from the other blind holes. This allows sections of the cooling channel to be widened or narrowed in order to slow down or speed up the flow of the cooling fluid. This makes it possible to better control the flow of the cooling fluid to cool specific parts of the heat generating element, particularly parts of the heat generating element that produce more excess heat than other parts. Thereby, the efficiency of the cooling unit cannot only be further increased, the cooling unit may also be tailored to specific heat generating elements.

In another embodiment, at least one of the blind holes has a depth different from the other blind holes. This allows sections of the cooling channel to be made deeper or shallower in order to slow down or speed up the flow of the cooling fluid. Like providing blind holes having different diameters, this makes it possible to better control the flow of the cooling fluid by changing the cross-section of the cooling channel. As mentioned above, the better control over the flow of cooling fluid further increases the efficiency of the cooling unit, and makes it possible to tailor the cooling unit to specific heat generating elements.

In another embodiment, at least some of the blind holes of the cooling channel are arranged on a straight line between the inlet channel and the outlet channel. The straight line is a very simple and easy to manufacture arrangement of the blind holes forming the cooling channel.

In another embodiment, at least some of the blind holes of the cooling channel are arranged in a staggered arrangement. The blind holes so arranged are formed along a waved line. Alternatively, or additionally, at least some of the blind holes of the cooling channel are arranged along any other suitable geometric shape, for example a meandering shape, a zig-zag shape or a spiral. The staggered arrangement can cover a greater area of the heat generating element, thereby reducing the number of required cooling channels and thus required power to pump the cooling fluid.

In another embodiment, the inlet channel is arranged such that the cooling fluid flows from the top into the cooling channel. In particular, the inlet channel is arranged such that the flow direction of the cooling fluid flowing to the cooling channel is perpendicular to the direction of cooling fluid flowing out of the cooling channel. In this embodiment, the cooling fluid flows into the cooling channel along the axes of the cylindrical blind holes. Thereby, the cooling channel or the cooling channels may be arranged between the inlet channel and the heat generating element. This makes it possible for the cold cooling liquid to enter the cooling channel or cooling channels close to the heat generating element where the temperature is expected to be the highest in order to more efficiently dissipate heat away from the heat generating element.

In another embodiment, the direction of cooling fluid flowing into the cooling channel is perpendicular to the direction of cooling fluid flowing out of the cooling channel. This arrangement is very space efficient. Another space efficient arrangement is to pace the inlet channel and the outlet channel at the opposite sides of the cooling channel.

In another embodiment, the cooling unit comprises a second outlet channel and at least one second cooling channel connecting the inlet channel to the second outlet channel allowing the cooling fluid to flow from the inlet channel to the second outlet channel in order to remove heat from the heat generating element. The second cooling channel may comprise cylindrical blind holes, the cylindrical blind holes being arranged such that the circular cross-sections of the blind holes partly overlap to form at least part of the second cooling channel. In particular, the first and second outlet channels may be arranged at opposite ends of the cooling unit. In this embodiment, the two cooling channels may be arranged such that the cooling fluid entering the cooling unit is directed into two opposite directions, in particular starting from a central region of the cooling unit. This arrangement makes it possible to dissipate more heat away from the central region where, for example, a region of the heat generating element may be arranged that produces more excess heat than other regions of the heat generating element. This makes it possible to further increases the efficiency of the cooling unit, and to tailor the cooling unit to specific heat generating elements.

In another embodiment, the first cooling channel and the second cooling channel are arranged next to each other such that a wall is formed between the two channels. The wall between the first and second cooling channels forms a cooling fin of the cooling unit. The wall may be formed in the central region of the cooling unit, forming the cooling fin where an increased rate of heat dissipation is needed, thereby greatly increasing the cooling efficiency of the cooling unit.

In another embodiment, the cooling unit comprises at least one element made from a single workpiece, said at least one element comprising the cooling channel. At least part of the inlet channel and/or the outlet channel may be formed in the at least one element. Manufacturing the at least one element from a single workpiece has the advantage that no discontinuities are created that would negatively affect the cooling units cooling performance.

In another embodiment, the at least one element is configured to be brought into thermal contact with the heat generating element. In this embodiment the at least one element forms a heat sink in which the heat sink structure is formed in.

In another embodiment, the at least one element is made from copper, aluminum, an alloy thereof, graphene or graphite. Other materials having a high thermal conductivity may be used for manufacturing the at least one element. The higher the thermal conductivity, the better the heat dissipation. The aforementioned materials have both a high thermal conductivity and can be easily manufactured into the cooling unit, making them ideal materials to use in manufacturing the cooling unit.

In another embodiment, the heat generating element is an electronic component, in particular an electronic component arranged on a PCB and/or a computer module. Alternatively, the heat generating element may be an engine such as an electric motor or an internal combustion engine, or an energy storage such as a battery or a super capacitor. The cooling unit may also be used in refrigeration.

The invention further relates to a method for manufacturing the cooling unit described above. The method comprises forming the blind holes by drilling. For example, the blind holes may be formed by machining a workpiece made from copper, aluminum, or an alloy thereof with drill bits of different diameters. Additional elements of the cooling unit, for example the inlet channel and the outlet channel, may also be formed by drilling. Alternatively, or additionally, other elements of the cooling unit may be formed by machining using a saw blade and/or a CNC-machine, in particular by milling on a CNC-machine. The method has the same advantages as the claimed cooling unit. In particular, the method can be supplemented with the features described in this document in connection with the cooling unit. Furthermore, the cooling unit can be supplemented with the features described in this document in connection with the method.

### Short Description of the Figures

Hereinafter, specific embodiments are described referring to the drawings, wherein:
- Figure 1: is a schematic exploded view of a cooling unit according to an embodiment shown from above;
- Figure 2: is a schematic exploded view of the cooling unit according to Figure 1 shown from below; and
- Figure 3: is a flowchart of a method for manufacturing the cooling unit according to Figures 1 and 2.

### Detailed Description

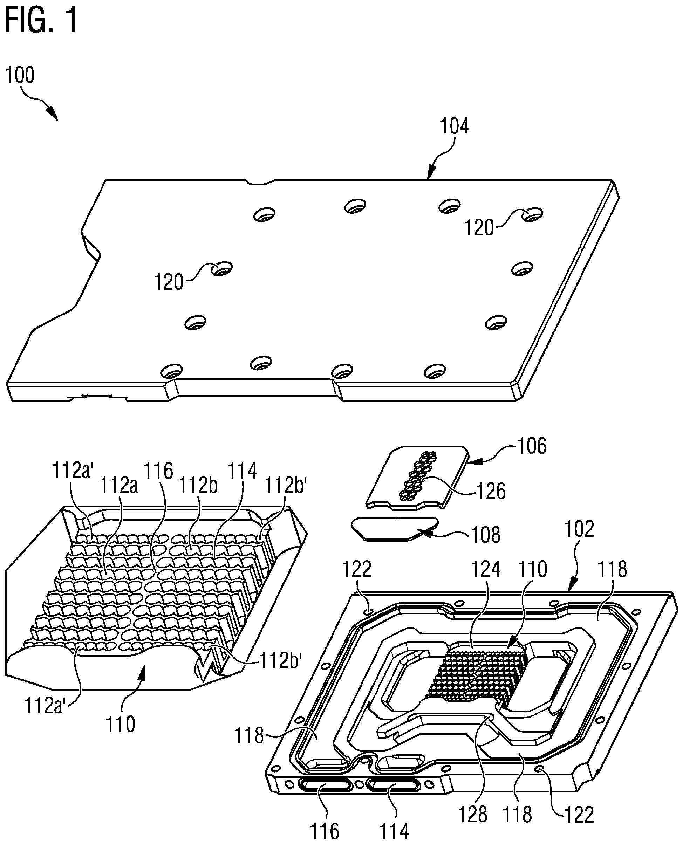

Figure 1 is a schematic exploded view of a cooling unit 100 according to an embodiment.

The cooling unit 100 is a fluid based cooling unit configured to cool a heat generating element using a cooling fluid, for example a liquid like water or a gas like air. The cooling fluid is directed through the cooling unit 100 to quickly transport excess heat away from the heat generating element, thereby cooling it. The heat generating element may be an electric or electronic component, for example a battery, a capacitor, or a CPU of a computer. However, the cooling unit 100 may also be used to cool an engine, for example an electric engine or an internal combustion engine, or any other heat generating element. In Figure 1 an exemplary embodiment of the cooling unit 100 is shown that may in particular be used for cooling an electronic component of a computer, such as a CPU or a GPU.

The cooling unit 100 comprises a first element 102 configured to be brought into thermal contact with the heat generating element, and a second element 104 configured to be arranged atop the first element 102. The cooling unit 100 further comprises a third element 106 and a fourth element 108 which are both configured to be arranged between the first element 102 and the second element 104. In the view of Figure 1, the aforementioned elements 102, 104, 106, 108 of the cooling unit 100 are shown in an oblique view from above.

The first element 102 comprises a heat sink structure 110 shown in the detail view in Figure 1. The heat sink structure 110 is located above the heat generating element when the cooling unit 100 is mounted to the heat generating element. The cooling fluid is passed through the heat sink structure 110 in order to remove excess heat from the heat generating element, and to transport the excess heat away from the heat generating element. The heat sink structure 110 comprises multiple cooling channels 112a, 112b, 112a', 112b' that are exemplary arranged parallel to each other. The cooling channels 112a, 112b, 112a', 112b' may be arranged in a different configuration, for example in a spiral comprising a single or multiple spiral arms spiraling out from the center of the arrangement. Other arrangements may be use as well, for example a meandering, zig-zag or staggered arrangement. Two parallel cooling channels 112a, 112b, 112a', 112b' form a wall 114 between them that acts as a cooling fin of the heat sink structure 110. The cooling channels 112a, 112b, 112a', 112b' are grouped into two groups separated by an additional wall 116 that is located centrally above the heat generating element and acts as an additional cooling fin. A first group of cooling channels 112a, 112a' directs the cooling fluid to the left in Figure 1, and a second group of cooling channels 112b, 112b' directs the cooling fluid to the right in Figure 1.

Each of the cooling channels 112a, 112b, 112a', 112b' comprises cylindrical blind holes arranged such that the circular cross-sections of the blind holes partly overlap. The overlapping blind holes create a jagged structure along the walls 114 formed between parallel cooling channels 112a, 112b, 112a', 112b'. The jagged structure creates turbulent flow in the cooling fluid, thereby increasing the ability of the flowing cooling fluid to interact with the walls 114 in order to remove excess heat. In the embodiment shown in Figure 1, the blind holes are arranged along parallel lines to form the cooling channels 112a, 112b, 112a', 112b'. The first blind holes of each cooling channel 112a, 112b, 112a', 112b', i.e. the blind holes located closest to the central wall 116. are arranged in a staggered fashion so that the central wall 116 itself is zig-zag shaped. The blind holes may also be arranged along other shapes to form the cooling channels 112a, 112b, 112a', 112b', for example along a waved line or a meandering line.

In the embodiment shown in Figure 1, the blind holes of the outermost cooling 112a', 112b' channels have a smaller diameter than the blind holes of the remaining cooling channels 112a, 112b. With the exception of the diameter of their blind holes the outermost cooling channels 112a', 112b' are identical to the remaining cooling channels 112a, 112b. Since the diameter of the blind holes is smaller, less cooling fluid is flowing through the outermost cooling channels 112a', 112b'.

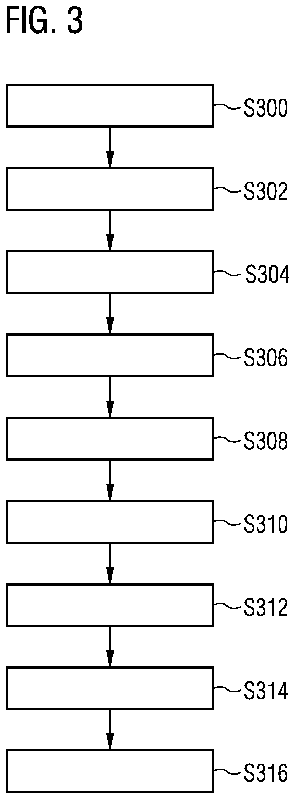

Further, in the present embodiment, all blind holes of a single cooling channel 112a, 112b, 112a', 112b' have the same diameter and depth in the present embodiment. In other embodiments, individual blind holes of a single channel may have different diameters and/or depth in order to control the flow of the cooling fluid. The blind holes are preferably formed by drilling. A method for manufacturing the cooling unit 100 by drilling the blind holes is described below with reference to Figure 3.

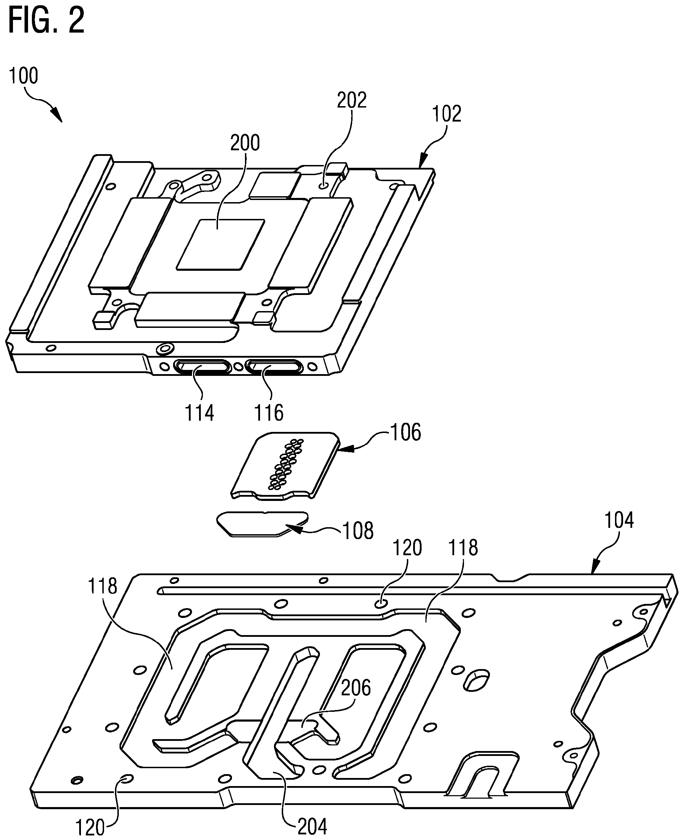

The first element 102 further comprises an inlet port 114 for allowing the cooling fluid to enter the cooling unit 100, and an outlet port 116 for allowing the cooling fluid to exit the cooling unit 100. The outlet port 116 is connected to the cooling channels 112a, 112b, 112a', 112b' of the heat sink structure 110 by an outlet channel 118. The outlet channel 118 allows the heated cooling fluid to flow from the heat sink structure 110 to the outlet port 116. In the embodiment shown in Figure 1, only a part of the outlet channel 118 is formed in the first element 102. The remaining part of the outlet channel 118 is formed in the second element 104, and is hidden from view in Figure 1. The remaining part of the outlet channel 118 is described in the following with reference to Figure 2.

The second element 104 is exemplary configured to be mounted to the first element 102 by means of screws. For this reason, the second element 104 comprises through holes 120 through which the screws can be passed. The screws passed through the through holes 120 in the second element 104 each engage a threaded blind hole 122 of the first element 102 to fasten the second element 104 to the first element 102. Before the first element 102 is fastened to the second element 104, the third element 106 and the fourth element 108 are arranged between the first element 102 and the second element 104. The third element 106 is placed in a first recess 124 in the first element 102 located above the heat sink structure 110. The third element 106 comprises through holes 126 that allow the cooling fluid to flow into the cooling channels 112a, 112b, 112a', 112b' when the third element 106 is placed above the heat sink structure 110. The fourth element 108 is placed in a second recess 128 formed in the first element 102. The second recess 128 is formed above a section of the outlet channel 118, so that the fourth element 108 seals the outlet channel 118 against an inlet channel 204 formed in the second element 104. The inlet channel 204 is hidden from view in Figure 1 and described in the following with reference to Figure 2. When the first element 102 is fastened to the second element 104, the cooling unit 100 is sealed, i.e. the cooling fluid can only enter and exit the cooling unit 100 via the inlet port 114 and the outlet port 116, respectively.

Figure 2 is a schematic exploded view of the cooling unit 100 according to Figure 1.

In the view of Figure 2, the elements 102, 104, 106, 108 of the cooling unit 100 are shown in an oblique view from below. As can be seen in Figure 2, structures are formed on the undersides of the first element 102 and the second element 104, respectively, that are hidden from view in Figure 1, and will be described in the following.

The first element 102 comprises a contact surface 200 formed at the underside of the first element 102. The contact surface 200 is configured to be brought into thermal contact with the heat generating element. In order to improve the heat transfer between the heat generating element and the first element 102, a thermal paste may be applied to the contact surface 200 and/or a surface of the heat generating element. The underside of the first element 102 further comprises screw holes 202 for mounting the first element 102 to the heat generating element or to an element mounting the heat generating element, for example a PCB or a computer module.

The underside of the second element 104 comprises another part of the outlet channel 118 connecting the heat sink structure 110 to the outlet port 116. The underside of the second element 104 also comprises the inlet channel 204 connecting the inlet port 114 to the upper side of the heat sink structure 110. The inlet channel 204 allows the cooling fluid to flow into the heat sink structure 110 from above via the through holes 126 of the third element 106. The underside of the second element 104 further comprises a recess 206 for receiving the fourth element 108 located below a section of the inlet channel 204. When the first element 102 is fastened to the second element 104 the inlet channel 204 is sealed against the outlet channel 118 by the fourth element 108. This prevents cold cooling fluid flowing towards the heat sink structure 110 from mixing with the heated cooling fluid flowing away from the heat sink structure 110.

Figure 3 is a flowchart of a method for manufacturing the cooling unit 100 according to Figures 1 and 2.

The process is started in step S300. In step S302 at least one workpiece is provided. The workpiece may in particular be a cuboid piece made from copper, aluminum, or an alloy thereof. However, other materials and/or shapes may be used, for example graphene or graphite. In step S304 the workpiece is machined in order to form the first element 102. The blind holes of the cooling channels 112a, 112b, 112a', 112b' are formed by drilling. The outlet channel 118 may be formed by drilling and/or milling. The inlet port 114 and the outlet port 116 are also formed by drilling and/or milling. In the optional step S306 the first recess 124 and/or the second recess 128 are formed in the first element 102 by drilling and/or milling. Alternatively, or additionally, the threaded blind holes 122 are created in the first element 102. The mounting plate 202 may also be fixed to the first element 102 in step S306. Further, in step S306 the contact surface 200 may be formed on the underside of the first element 102.

In step 308 the second element 104 is machined from the same or another workpiece. The inlet channel 204 and the outlet channel 118 may be formed by drilling and/or milling. In the optional step S310 the recess 206 located below the inlet channel 204 is formed in the second element 104 by drilling and/or milling. Further, in step S310 the through holes 120 for guiding the screws may be formed by drilling in step S310. In step S312, the third element 106 and/or the fourth element 108 are manufactured. The third element 106 and/or the fourth element 108 may be cut from a sheet made from copper, aluminum, an alloy thereof, graphene or graphite. The through holes 126 in the third element 106 may in particular be formed by drilling. The steps S304 to S312 may be performed in any order. Additionally, any or all of the steps S304 to S312 may be performed concurrently. In step S314 the cooling unit 100 is assembled, and in step S316 the method is ended.

Identical or similarly acting elements are designated with the same reference signs in all Figures. As used herein the term "and/or" includes any and all combinations of one or more of the associated listed items.

### List of reference signs

- 100: Cooling unit
- 102, 104, 106, 108: Elements
- 110: Heat sink structure
- 112a, 112b, 112a', 112b': Cooling channel
- 114: Inlet port
- 116: Outlet port
- 118: Outlet channel
- 120: Through hole
- 122: Threaded blind hole
- 124: Recess
- 126: Through holes
- 128: Recess
- 200: Contact surface
- 202: Screw holes
- 204: Inlet channel
- 206: Recess

## Claims

1. Fluid-based cooling unit (100) for cooling a heat generating element, the cooling unit (100) comprising:
at least one inlet channel (204) configured to allow a cooling fluid to flow into the cooling unit (100);
at least one outlet channel (118) configured to allow a cooling fluid to flow out of the cooling unit (100);
at least one cooling channel (112a, 112b, 112a', 112b') connecting the inlet channel (204) to the outlet channel (118) allowing the cooling fluid to flow from the inlet channel (204) to the outlet channel (118) in order to remove heat from the heat generating element,
wherein
the cooling channel (112a, 112b, 112a', 112b') comprises cylindrical blind holes, the cylindrical blind holes being arranged such that the circular cross-sections of the blind holes partly overlap in order to form at least part of the cooling channel (112a, 112b, 112a', 112b').

2. Cooling unit (100) according to claim 1, comprising at least two cooling channels (112a, 112b, 112a', 112b') arranged next to each other such that a wall (114, 116) is formed between the at least two channels, wherein the wall (114, 116) between the cooling channels (112a, 112b, 112a', 112b') forms a cooling fin of the cooling unit (100).

3. Cooling unit (100) according to claim 1 or 2, wherein at least one of the blind holes has a diameter different from the other blind holes.

4. Cooling unit (100) according to any one of the preceding claims, wherein at least one of the blind holes has a depth different from the other blind holes.

5. Cooling unit (100) according to any one of the preceding claims, wherein at least some of the blind holes of the cooling channel (112a, 112b, 112a', 112b') are arranged on a straight line between the inlet channel (204) and the outlet channel (118).

6. Cooling unit (100) according to any one of the preceding claims, wherein at least some of the blind holes of the cooling channel (112a, 112b, 112a', 112b') are arranged in a staggered arrangement.

7. Cooling unit (100) according to any one of the preceding claims, wherein the inlet channel (204) is arranged such that the cooling fluid flows from the top into the cooling channel (112a, 112b, 112a', 112b').

8. Cooling unit (100) according to any one of the preceding claims, wherein the direction of cooling fluid flowing into the cooling channel (112a, 112b, 112a', 112b') is perpendicular to the direction of cooling fluid flowing out of the cooling channel (112a, 112b, 112a', 112b').

9. Cooling unit (100) according to any one of the preceding claims, comprising a second outlet channel (118) and at least one second cooling channel (112b, 112b') connecting the inlet channel (204) to the second outlet channel (118) allowing the cooling fluid to flow from the inlet channel (204) to the second outlet channel (118) in order to remove heat from the heat generating element; wherein the second cooling channel (112b, 112b') comprises cylindrical blind holes, the cylindrical blind holes being arranged such that the circular cross-sections of the blind holes partly overlap to form at least part of the second cooling channel (112b, 112b').

10. Cooling unit (100) according to claim 9, wherein the first cooling channel (112a, 112a') and the second cooling channel (112b, 112b') are arranged next to each other such that a wall (116) is formed between the two channels, wherein the wall (116) between the first and second cooling channels (112a, 112b, 112a', 112b') forms a cooling fin of the cooling unit (100).

11. Cooling unit (100) according to any one of the preceding claims, comprising at least one element (102) made from a single workpiece, said at least one element (102) comprising the cooling channel (112a, 112b, 112a', 112b').

12. Cooling unit (100) according to claim 11, wherein the at least one element (102) is configured to be brought into thermal contact with the heat generating element.

13. Cooling unit (100) according to claim 11 or 12, wherein the at least one element (102) is made from copper, aluminum, an alloy thereof, graphene or graphite.

14. Cooling unit (100) according to any one of the preceding claims, wherein the heat generating element is an electronic component, in particular an electronic component arranged on a PCB and/or a computer module.

15. Method for manufacturing the cooling unit (100) according to any of the preceding claims, wherein the blind holes are formed by drilling.
